# EUROPEAN PATENT APPLICATION

(11) **EP 4 471 446 A1**
(43) Date of publication of application: **04.12.2024**
(21) Application number: 23176414.3
(22) Date of filing: 31.05.2023
(51) Int. Cl.: G01R 33/028, G01R 33/12, G01V 3/08

(54) **SENSOR ARRANGEMENT**

(71) Applicant: Frauscher Sensortechnik GmbH, 4774 St. Marienkirchen (AT)
(72) Inventor: Schratzberger, Josef, 4773 Eggerding (AT)
(74) Representative: Epping - Hermann - Fischer

(57) **Abstract**

A sensor arrangement (20) is provided, the sensor arrangement (20) comprising at least one sender coil (21), and at least one receiver coil (22), wherein the sender coil (21) or the receiver coil (22) comprises at least one first partial coil (23) and at least one second partial coil (24), the first partial coil (23) and the second partial coil (24) each have at least one winding, and the winding direction of the first partial coil (23) is opposite to the winding direction of the second partial coil (24) so that a change in inductive coupling between the sender coil (21) and the receiver coil (22) nullifies for a change of electrical or magnetic properties of a linear asset (25) being arranged adjacent to the sensor arrangement (20), the change being homogenous along at least a part of the linear asset (25).

## Description

A sensor arrangement is provided.

Inductive sensors can be employed for detecting electrically conductive or magnetizable objects in the vicinity of the sensor. For this purpose an inductive sensor may consist of a sender coil and a receiver coil that are inductively coupled. Once an electrically conductive or magnetizable object is present in the vicinity of the sensor, the inductive coupling changes. In this way, the object can be detected.

The inductive coupling can also be changed by a change in electrical or magnetic properties of a material in the vicinity of the sensor. Thus, from the change in inductive coupling it is in many cases not possible to distinguish the displacement of an object from a change in electrical or magnetic properties of a material in the vicinity of the sensor. This leads to insecurities in detecting metallic objects.

It is an objective to provide a sensor arrangement with an improved reliability.

This objective is achieved with the independent claim. Further embodiments are the subject of dependent claims.

According to at least one embodiment of the sensor arrangement, the sensor arrangement comprises at least one sender coil. The sender coil can have at least one winding. Another expression for winding is convolution. The sender coil can comprise an electrically conductive material that forms at least one winding. It is possible that the sender coil has a plurality of windings. The sender coil can be free of a core comprising a magnetically permeable material. The winding direction of the sender coil can change at least once along the sender coil. This can mean that that the sender coil has at least two parts that have opposite winding directions. The winding direction of the sender coil can change more than once along the sender coil. The sender coil or a part of the sender coil can be connected with a power source. The power source can be comprised by the sensor arrangement or it can be an external component. The power source can be configured to provide the sender coil with power, for example with an alternating voltage.

According to at least one embodiment of the sensor arrangement, the sensor arrangement comprises at least one receiver coil. The receiver coil can have at least one winding. The receiver coil can comprise an electrically conductive material that forms least one winding. It is possible that the receiver coil has a plurality of windings. The receiver coil can be free of a core comprising a magnetically permeable material. The winding direction of the receiver coil can change at least once along the receiver coil. This can mean that that the receiver coil has at least two parts that have opposite winding directions. The winding direction of the receiver coil can change more than once along the receiver coil. The inductive coupling between the sender coil and the receiver coil can be below 5 %, below 2 % or below 1 %. The receiver coil can be arranged spaced apart from the sender coil. This can mean, that the sender coil and the receiver coil are not in direct contact with each other. The sensor arrangement can be free from an electrical connection between the sender coil and the receiver coil. The sender coil and the receiver coil can be arranged above one another.

According to at least one embodiment of the sensor arrangement, the sender coil or the receiver coil comprises at least one first partial coil and at least one second partial coil. The first partial coil and the second partial coil together can form the sender coil or the receiver coil. Thus, the first partial coil can be electrically connected with the second partial coil. The first partial coil can be in direct contact with the second partial coil. It is also possible that the first partial coil is arranged spaced apart from the second partial coil. Thus, the first partial coil is not necessarily in direct contact with the second partial coil. It is possible that the first partial coil is not in direct contact with the second partial coil.

According to at least one embodiment of the sensor arrangement, the first partial coil and the second partial coil each have at least one winding. Each winding can be formed by an electrically conductive material. It is also possible that the first partial coil and/or the second partial coil has a plurality of windings.

According to at least one embodiment of the sensor arrangement, the winding direction of the first partial coil is opposite to the winding direction of the second partial coil so that a change in inductive coupling between the sender coil and the receiver coil is minimized or nullifies for a change of electrical or magnetic properties of a linear asset being arranged adjacent to the sensor arrangement, the change being homogenous along at least a part of the linear asset. That the winding direction of the first partial coil is opposite to the winding direction of the second partial coil can mean that the first partial coil is wound or turns in the opposite direction in comparison to the second partial coil.

The inductive coupling between the sender coil and the receiver coil can be larger than zero. The inductive coupling between the sender coil and the receiver coil changes for example if electrically conductive material or magnetizable material is displaced within the magnetic field of the sender coil. It is also possible that the inductive coupling between the sender coil and the receiver coil changes for the case that electrical or magnetic properties of a material arranged within the magnetic field of the sender coil change. The sensor arrangement can have a detection range within which it is sensitive to a displacement of electrically conductive material or magnetizable material. It is also possible that the sensor arrangement is sensitive to a change of electrical or magnetic properties of a material arranged within the detection range. That the sensor arrangement is sensitive can mean in this context that the inductive coupling between the sender coil and the receiver coil changes.

A change in the inductive coupling between the sender coil and the receiver coil leads to a voltage difference being induced in the receiver coil. If the change in inductive coupling between the sender coil and the receiver coil nullifies, it is possible that also the induced voltage difference nullifies. This can mean that the sum of induced voltages amounts to zero or nearly zero.

The inductive coupling between the sender coil and the receiver coil can be given by the sum of at least two components. For a change of electrical or magnetic properties of the linear asset, the change being homogenous along at least a part of the linear asset, the sum of the at least two components amounts to zero or nearly zero. This can mean, that the part of the inductive coupling between the sender coil and the receiver coil that is caused by a homogenous change of electrical or magnetic properties of the linear asset in sum amounts to zero or nearly zero. In this way, an impact of a homogenous change of electrical or magnetic properties of the linear asset on the total amount of the inductive coupling between the sender coil and the receiver coil is avoided.

This can for example be achieved with the first partial coil and the second partial coil of the receiver coil. If the receiver coil comprises the first partial coil and the second partial coil, the inductive coupling between the sender coil and the receiver coil depends on two components, namely the inductive coupling between the sender coil and the first partial coil, and the inductive coupling between the sender coil and the second partial coil. These two components compensate each other for a homogenous change of electrical or magnetic properties of the linear asset. In other words, the sum of the inductive coupling between the sender coil and the first partial coil and the inductive coupling between the sender coil and the second partial coil caused by a homogenous change of electrical or magnetic properties of the linear asset amounts to zero or nearly zero. That the sum is zero or nearly zero can for example be achieved by at least one component of the sum being positive and at least one component of the sum being negative. This is achieved in the same way if the sender coil comprises the first partial coil and the second partial coil.

That the change in the inductive coupling nullifies can mean, that this inductive coupling equals to zero or is nearly zero. That the change in the inductive coupling nullifies can also mean, that the change in the inductive coupling mainly nullifies.

The sensor arrangement can be arranged adjacent to a linear asset. The linear asset can be arranged within the magnetic field of the sender coil. The linear asset can be arranged within the detection range of the sensor arrangement. The linear asset can be for example a railway track, a fence or a pipeline. The linear asset can be any asset that extends along a line. The linear asset can have electrical and/or magnetic properties. In the case of a railway track, the rail and/or the rails can have an electrical conductivity and they can be magnetizable. The electrical conductivity of a rail can be dependent on the temperature of the rail. Also strong electrical currents within the rail can cause a change in magnetic properties due to the nonlinear magnetic behaviour of typical rail steel. Such a change in the electrical or magnetic properties of the linear asset usually leads to a change in the inductive coupling between the sender coil and the receiver coil.

A change in the electrical or magnetic properties of the linear asset can be homogenous along at least a part of the linear asset. This can mean that the electrical or magnetic properties change in the same way along at least a part of the linear asset. In other words, electrical or magnetic properties of the linear asset can change in the same way for at least a part of the linear asset. As an example, if a current flows in the linear asset, the current is the same for at least a part of the linear asset. The current leads in this case to the change in the electrical or magnetic properties of the linear asset. Therefore, such a change of electrical or magnetic properties of the linear asset is referred to as being homogeneous along at least a part of the linear asset. For such a homogeneous change of the electrical or magnetic properties of the linear asset, the change in inductive coupling between the sender coil and the receiver coil nullifies.

The change in the electrical or magnetic properties of the linear asset can be homogenous over a distance of more than10 times the typical coil diameter, for example over several meters. The part of the linear asset along which the electrical or magnetic properties of the linear asset change homogenously can extend around the position of the linear asset that is the closest to the sensor arrangement. In other words, the part of the linear asset along which the electrical or magnetic properties of the linear asset change homogeneously can be arranged in the vicinity of the sensor arrangement. In this way, the inductive coupling between the sender coil and the receiver coil is influenced by the electrical or magnetic properties of that part of the linear asset.

A change of the electrical or magnetic properties of the linear asset that is homogenous along at least a part of the linear asset can for the example of a railway track be the magnetic saturation of a rail. Another example for a railway track is the case that a current is flowing in a rail.

It is also possible that electrical or magnetic properties of the linear asset change due to other reasons. Changes that are not homogenous along at least a part of the linear asset but are localized are also possible. The changes of electrical or magnetic properties of the linear asset referred to herein are therefore not the only possible changes of electrical or magnetic properties of the linear asset.

The sensor arrangement can be or comprise a detector for electrically conductive material. The sensor arrangement can be or comprise a metal detector. The metal detector can be an inductive metal detector. The metal detector can be operated based on induction balance. The sensor arrangement can be configured to detect displacement of electrically conductive material. The sensor arrangement can be configured to detect displacement of electrically conductive material in the vicinity of the sensor arrangement. For detecting the displacement of electrically conductive material, the inductive coupling between the sender coil and the receiver coil can be analyzed. For this purpose, the sensor arrangement can comprise evaluating electronics. A change in the inductive coupling between the sender coil and the receiver coil leads to a voltage being induced in the receiver coil. This voltage can for example be detected with a voltmeter.

According to at least one embodiment of the sensor arrangement, the sensor arrangement comprises at least one sender coil, and at least one receiver coil, wherein the sender coil or the receiver coil comprises at least one first partial coil and at least one second partial coil, the first partial coil and the second partial coil each have at least one winding, and the winding direction of the first partial coil is opposite to the winding direction of the second partial coil so that a change in inductive coupling between the sender coil and the receiver coil nullifies for a change of electrical or magnetic properties of a linear asset being arranged adjacent to the sensor arrangement, the change being homogenous along at least a part of the linear asset.

The sensor arrangement can for example be employed for detecting electrically conductive or magnetizable material in the vicinity of the sensor arrangement. With the sensor arrangement being arranged adjacent to the linear asset, objects comprising an electrically conductive or magnetizable material along the linear asset can be detected. As an example, the sensor arrangement can be employed to detect the presence of wheels of rail vehicles passing along the sensor arrangement. The presence of electrically conductive or magnetizable material in the vicinity of the sensor arrangement leads to a change in the inductive coupling between the sender coil and the receiver coil. In this way, the material can be detected.

However, also other circumstances can lead to a change in the inductive coupling between the sender coil and the receiver coil, for example a change of electrical or magnetic properties of a linear asset being arranged adjacent to the sensor arrangement, the change being homogenous along at least a part of the linear asset. From the change in the inductive coupling between the sender coil and the receiver coil it might not in each case be possible to distinguish between the displacement of electrically conductive or magnetizable material such as a wheel of a rail vehicle and a change of electrical or magnetic properties of the linear asset. This can lead to insecurities in detecting the displacement of electrically conductive or magnetizable material.

Advantageously, in the sensor arrangement described herein the change in inductive coupling between the sender coil and the receiver coil nullifies for a change of electrical or magnetic properties of the linear asset, the change being homogenous along at least a part of the linear asset. Therefore, a change of electrical or magnetic properties of the linear asset that is homogenous along at least a part of the linear asset has no or nearly no impact on the detection of the displacement of electrically conductive or magnetizable material. In the case that the linear asset is a railway track, this means, that a magnetic saturation of a rail, a change in the temperature of a rail and/or currents within the rail have no or nearly no impact on the detection of the displacement of electrically conductive or magnetizable material. In this way, the reliability of detecting the displacement of electrically conductive or magnetizable material is improved.

Since the change in inductive coupling between the sender coil and the receiver coil nullifies for a homogenous change of electrical or magnetic properties of the linear asset, this change of the electrical or magnetic properties of the linear asset has no or nearly no impact on the amplitude of the inductive coupling between the sender coil and the receiver coil. Therefore, the sensitivity of detecting displacement of electrically conductive or magnetizable material is not or nearly not influenced by a homogenous change of electrical or magnetic properties of the linear asset.

In order to achieve that a change in inductive coupling between the sender coil and the receiver coil nullifies for a homogenous change of electrical or magnetic properties of the linear asset, it is not necessary that the first partial coil and the second partial coil have the same shape. In other words, no geometric symmetry of the first partial coil and the second partial coil is required. The first partial coil can for example have a shape that is different from the shape of the second partial coil. It is also possible that the number of windings of the first partial coil is different from the number of windings of the second partial coil. The first partial coil and the second partial coil having different shapes has the advantage that the measurement of the velocity of a passing wheel of a rail vehicle is possible with only one sensor arrangement. With the first partial coil and the second partial coil having different shapes a signal detected by the receiver coil has an asymmetric shape. From this signal the velocity of a wheel of the rail vehicle at the position of the sensor arrangement can be determined. It is also possible to determine the direction of travel of the wheel passing the position of the sensor arrangement.

It is also possible that the first partial coil and the second partial coil have the same shape and setup.

According to at least one embodiment of the sensor arrangement, the sensor arrangement comprises at least one sender coil, and at least one receiver coil, wherein the sender coil or the receiver coil comprises at least one first partial coil and at least one second partial coil, the first partial coil and the second partial coil each have at least one winding, and the winding direction of the first partial coil is opposite to the winding direction of the second partial coil. With this setup of the sensor arrangement it is achieved that a change in inductive coupling between the sender coil and the receiver coil is minimized or nullifies for a change of electrical or magnetic properties of the linear asset being arranged adjacent to the sensor arrangement, the change being homogenous along at least a part of the linear asset. The first partial coil and the second partial coil can have the same setup or the setup of the first partial coil can be different from the setup of the second partial coil.

According to at least one embodiment of the sensor arrangement, the change of electrical or magnetic properties of the linear asset is homogenous along at least a part of the linear asset along the main extension direction of the linear asset. This can mean that the change of electrical or magnetic properties of the linear asset is homogenous along the main extension direction of the linear asset along at least a part of the linear asset. The main extension direction of the linear asset can be a line along which the linear asset extends. If for example the electrical properties of the linear asset change due to a change in temperature of the linear asset, this change in temperature can be the same or approximately the same along at least a part of the linear asset. Therefore, for this part of the linear asset the change in electrical properties of the linear asset due to the temperature change is homogenous along the main extension direction of the linear asset. If for example the electrical and magnetic properties of the linear asset change due to a current flowing in a rail, this current can be the same or approximately the same along at least a part of the rail. Therefore, for this part of the rail the change in electrical and magnetic properties due to the current is homogenous along the main extension direction of the rail. For example for monitoring the linear asset it is advantageous that changes in the electrical or magnetic properties of the linear asset that are homogenous along at least a part of the linear asset do not significantly affect the detection of metallic objects. Thus, the displacement of objects along the linear asset can be detected with an improved reliability.

According to at least one embodiment of the sensor arrangement, the first partial coil and the second partial coil are arranged next to each other along the main extension direction of the linear asset. This can mean, that the first partial coil and the second partial coil follow after one another along the main extension direction of the linear asset. The first partial coil and the second partial coil can be arranged next to each other along the main extension direction of the linear asset, wherein the main extension direction refers to the main extension direction adjacent to the sensor arrangement. With the first partial coil and the second partial coil being arranged next to each other along the main extension direction of the linear asset, it is possible to detect a signal with the receiver coil that provides information about the direction of travel of a passing wheel of a rail vehicle. From the signal detected with the receiver coil it can be inferred which of the first partial coil and the second partial coil the wheel passed at first.

According to at least one embodiment of the sensor arrangement, the first partial coil and the second partial coil are connected in series. The first partial coil and the second partial coil can be electrically connected in series with each other. In this way, the first partial coil and the second partial coil can together form the sender coil or the receiver coil.

According to at least one embodiment of the sensor arrangement, the coil axis of the first partial coil extends parallel to the coil axis of the second partial coil. For a coil its coil axis can extend perpendicular to the plane in which a winding of the coil is arranged. The first partial coil and the second partial coil can thus have the same orientation with respect to the linear asset. This enables that a change in inductive coupling between the sender coil and the receiver coil nullifies for a change of electrical or magnetic properties of the linear asset, the change being homogenous along at least a part of the linear asset.

According to at least one embodiment of the sensor arrangement, the coil axis of the first partial coil and the coil axis of the second partial coil extend parallel to the coil axis of the sender coil or to the coil axis of the receiver coil. If the sender coil comprises the first partial coil and the second partial coil, the coil axis of the first partial coil and the coil axis of the second partial coil can extend parallel to the coil axis of the receiver coil. If the receiver coil comprises the first partial coil and the second partial coil, the coil axis of the first partial coil and the coil axis of the second partial coil can extend parallel to the coil axis of the sender coil. The parallel arrangement of the coil axes enables a cost-effective and simplified production of the sensor arrangement.

According to at least one embodiment of the sensor arrangement, the first partial coil has the same winding direction as the sender coil or the receiver coil. If the sender coil comprises the first partial coil, the first partial coil can have the same winding direction as the receiver coil. If the receiver coil comprises the first partial coil, the first partial coil can have the same winding direction as the sender coil. This enables that a change in inductive coupling between the sender coil and the receiver coil nullifies for a change of electrical or magnetic properties of the linear asset, the change being homogenous along at least a part of the linear asset.

According to at least one embodiment of the sensor arrangement, the second partial coil has the same winding direction as the sender coil or the receiver coil. If the sender coil comprises the second partial coil, the second partial coil can have the same winding direction as the receiver coil. If the receiver coil comprises the second partial coil, the second partial coil can have the same winding direction as the sender coil. This enables that a change in inductive coupling between the sender coil and the receiver coil nullifies for a change of electrical or magnetic properties of the linear asset, the change being homogenous along at least a part of the linear asset.

According to at least one embodiment of the sensor arrangement, the first partial coil has a shape and/or a size that is different from the shape and/or size of the second partial coil. The first partial coil can have a shape that is different from the shape of the second partial coil. The first partial coil can have a size that is different from the size of the second partial coil. The first partial coil and the second partial coil having different shapes and/or sizes has the advantage that the measurement of the velocity of a passing wheel of a rail vehicle is possible with only one sensor arrangement. It is also possible with only one sensor arrangement to determine the direction of travel of a wheel passing the position of the sensor arrangement.

According to at least one embodiment of the sensor arrangement, the first partial coil has a number of windings that is different from the number of windings of the second partial coil. The first partial coil and the second partial coil having different numbers of windings and thus different shapes has the advantage that the measurement of the velocity of a passing wheel of a rail vehicle is possible with only one sensor arrangement. It is also possible with only one sensor arrangement to determine the direction of travel of a wheel passing the position of the sensor arrangement.

According to at least one embodiment of the sensor arrangement, the sender coil has a size that is different from the size of the receiver coil. The sender coil can be larger than the receiver coil or the sender coil can be smaller than the receiver coil.

According to at least one embodiment of the sensor arrangement, the first partial coil has a resonant frequency which is different from the resonant frequency of the second partial coil. In this way, resonant inductive or capacitive coupling between the first partial coil and the second partial coil is avoided.

According to at least one embodiment of the sensor arrangement, the sender coil or the receiver coil comprises at least one third partial coil. The third partial coil can have the same properties as the first partial coil or the second partial coil. Thus, the third partial coil can have the same setup as the first partial coil or the second partial coil. The first partial coil, the second partial coil and the third partial coil can be electrically connected with each other in series. The second partial coil can be arranged between the first partial coil and the third partial coil along the main extension direction of the linear asset. By employing a third partial coil, there is more freedom in the setup of the sensor arrangement for achieving a setup where a change in inductive coupling between the sender coil and the receiver coil nullifies for a change of electrical or magnetic properties of the linear asset, the change being homogenous along at least a part of the linear asset.

According to at least one embodiment of the sensor arrangement, the sensor arrangement is mountable to the linear asset. The sensor arrangement can comprise a carrier. The carrier can be mountable to the linear asset. For example, the sensor arrangement is mountable to a rail. In this way, the sensor arrangement can be employed in railway monitoring and/or railway diagnostics.

According to at least one embodiment of the sensor arrangement, the coil axis of the first partial coil and/or the coil axis of the second partial coil extend perpendicular to the plane on which the linear asset is arranged. For example, the coil axis of the first partial coil and/or the coil axis of the second partial coil extend perpendicular to the ground on which the linear asset is arranged. With this setup of the sensor arrangement a change in inductive coupling between the sender coil and the receiver coil nullifies for a change of electrical or magnetic properties of the linear asset, the change being homogenous along at least a part of the linear asset. It is also possible that the coil axis of the first partial coil extends perpendicular to the coil axis of the second partial coil.

According to at least one embodiment of the sensor arrangement, the first partial coil and/or the second partial coil is connected with a voltmeter. It is also possible that:
- the first partial coil and the second partial coil are connected with voltmeters,
- the first partial coil and the second partial coil are connected with a common voltmeter.

The voltmeter can be configured to measure a voltage induced in the first partial coil and/or the second partial coil. From the measurement of the induced voltage it can be determined if electrically conductive or magnetizable material moves in the vicinity of the sensor arrangement.

The following description of figures may further illustrate and explain exemplary embodiments. Components that are functionally identical or have an identical effect are denoted by identical references. Identical or effectively identical components might be described only with respect to the figures where they occur first. Their description is not necessarily repeated in successive figures.
Figure 1 shows an exemplary embodiment of the sensor arrangement.
Figure 2 shows another exemplary embodiment of the sensor arrangement.
Figure 3 shows a cross-section through an exemplary embodiment of the sensor arrangement.
Figures 4, 5, 6 and 7 show further exemplary embodiments of the sensor arrangement.
Figure 8 shows a signal detected with an exemplary embodiment of the sensor arrangement.

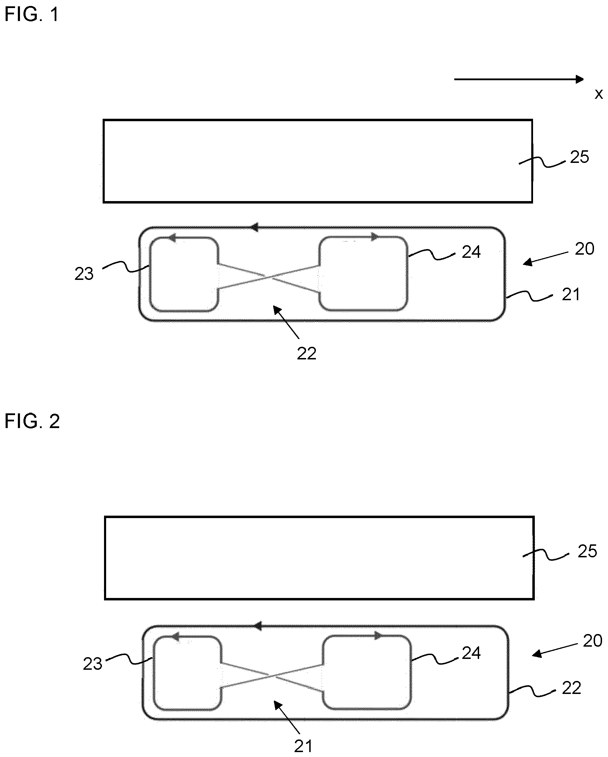

Figure 1 shows a top view on an exemplary embodiment of the sensor arrangement 20. The sensor arrangement 20 is arranged adjacent to a linear asset 25 which is for example a rail. The sensor arrangement 20 comprises a sender coil 21. The sensor arrangement 20 further comprises a receiver coil 22. The receiver coil 22 comprises a first partial coil 23 and a second partial coil 24. The first partial coil 23 and the second partial coil 24 each have at least one winding. The winding direction of the first partial coil 23 is opposite to the winding direction of the second partial coil 24 so that a change in inductive coupling between the sender coil 21 and the receiver coil 22 nullifies for a change of electrical or magnetic properties of a linear asset 25 being arranged adjacent to the sensor arrangement 20, the change being homogenous along at least a part of the linear asset 25. The winding directions are indicated by arrows on the respective coils 21, 23, 24. The change of electrical or magnetic properties of the linear asset 25 is homogenous along at least a part of the linear asset 25 along the main extension direction x of the linear asset 25. The main extension direction x of the linear asset 25 is shown with an arrow in figure 1.

The first partial coil 23 and the second partial coil 24 are arranged next to each other along the main extension direction x of the linear asset 25. The first partial coil 23 and the second partial coil 24 can be connected in series. The coil axis of the first partial coil 23 extends parallel to the coil axis of the second partial coil 24. The coil axis of the first partial coil 23 and the coil axis of the second partial coil 24 extend parallel to the coil axis of the sender coil 21. The first partial coil 23 has the same winding direction as the sender coil 21.

The first partial coil 23 has a size that is different from the size of the second partial coil 24. The first partial coil 23 is smaller than the second partial coil 24. The first partial coil 23 can have a number of windings that is different from the number of windings of the second partial coil 24. The first partial coil 23 can have a resonant frequency which is different from the resonant frequency of the second partial coil 24.

The sender coil 21 has a size that is different from the size of the receiver coil 22. The sender coil 21 is larger than the receiver coil 22. The sender coil 21 can be arranged around the receiver coil 22. It is however also possible that the sender coil 21 and the receiver coil 22 are arranged above one another. Figure 1 shows a top view where the sender coil 21 and the receiver coil 22 are depicted in the same plane.

Figure 2 shows a top view on another exemplary embodiment of the sensor arrangement 20 arranged adjacent to a linear asset 25. The sensor arrangement 20 has the same setup as shown in figure 1 with the only difference that instead of the receiver coil 22 the sender coil 21 comprises the first partial coil 23 and the second partial coil 24. The coil axis of the first partial coil 23 and the coil axis of the second partial coil 24 extend parallel to the coil axis of the receiver coil 22. The first partial coil 23 has the same winding direction as the receiver coil 22.

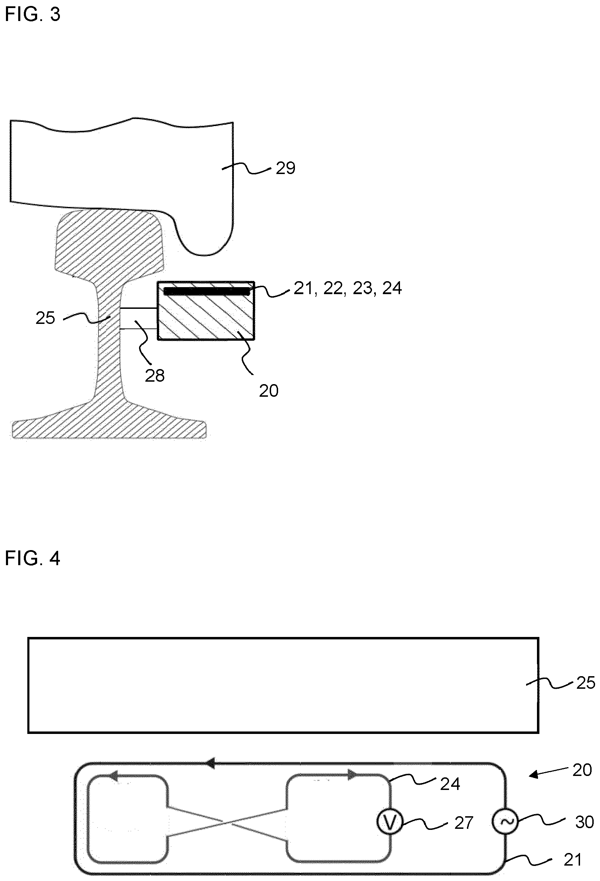

Figure 3 shows a cross-section through an exemplary embodiment of the sensor arrangement 20. The sensor arrangement 20 with the sender coil 21 and the receiver coil 22 is mounted to the linear asset 25 which is a rail. For this purpose, the sensor arrangement 20 can comprise a carrier 28. The carrier 28 is connected to the rail. On the top of the rail a part of a wheel 29 of a rail vehicle is depicted. The sensor arrangement 20 is thus arranged in close proximity to the wheel 29. In this way, the inductive coupling between the sender coil 21 and the receiver coil 22 is changed by the passage of a wheel 29 of a rail vehicle. Therefore, the displacement of rail vehicles can be detected with the sensor arrangement 20.

The first partial coil 23 and the second partial coil 24 can be arranged as shown in figure 1 or as shown in figure 2. In the cross section it can be seen that the coil axis of the first partial coil 23 and the coil axis of the second partial coil 24 extend perpendicular to the plane on which the linear asset 25 is arranged.

Figure 4 shows a top view on another exemplary embodiment of the sensor arrangement 20 arranged adjacent to a linear asset 25. The only difference to the sensor arrangement 20 shown in figure 1 is that the second partial coil 24 is connected with a voltmeter 27 and the sender coil 21 is connected with a power source 30. The power source 30 can be configured to provide an alternating voltage to the sender coil 21.

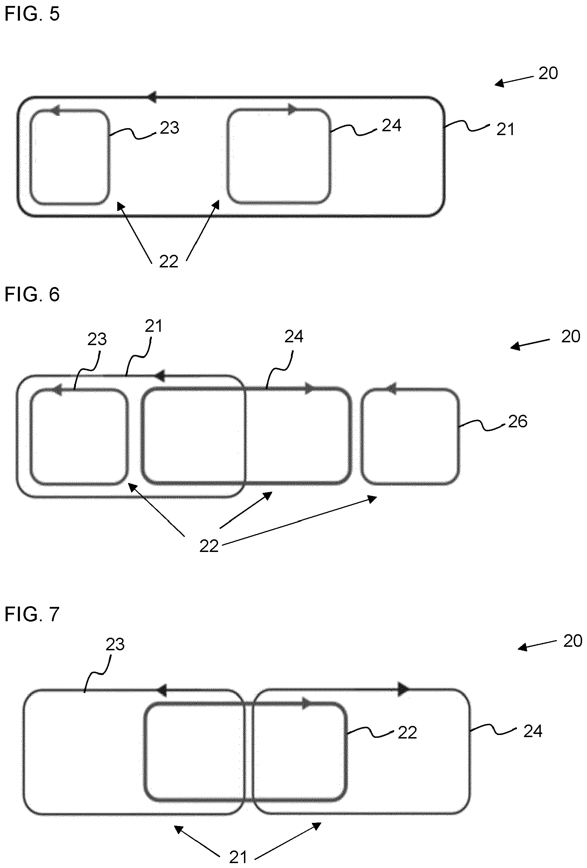

Figure 5 shows a top view on another exemplary embodiment of the sensor arrangement 20. The linear asset 25 is not shown. In comparison to the sensor arrangement 20 shown in figure 1, in the sensor arrangement 20 of figure 5 the first partial coil 23 and the second partial coil 24 are not connected in series. The sender coil 21 and the receiver coil 22 can have the same orientation with respect to the linear asset 25 as shown in figure 1.

Figure 6 shows a top view on another exemplary embodiment of the sensor arrangement 20. In comparison to the sensor arrangement 20 shown in figure 1, in the sensor arrangement 20 of figure 6 the receiver coil 22 comprises a third partial coil 26. The first partial coil 23 and the third partial coil 26 have the same winding direction as the sender coil 21. The second partial coil 24 is arranged between the first partial coil 23 and the third partial coil 26. The first partial coil 23 and the third partial coil 26 are smaller than the second partial coil 24. The first partial coil 23, the second partial coil 24 and the third partial coil 26 can be electrically connected in series. The sender coil 21 does not completely surround the receiver coil 22 as shown in figure 1 but the sender coil 21 partially overlaps with the receiver coil 22. The sender coil 21 and the receiver coil 22 can have the same orientation with respect to the linear asset 25 as shown in figure 1. Therefore, the first partial coil 23, the second partial coil 24 and the third partial coil 26 can be arranged next to each other along the main extension direction x of the linear asset 25.

Figure 7 shows a top view on another exemplary embodiment of the sensor arrangement 20. The sender coil 21 comprises the first partial coil 23 and the second partial coil 24. The sender coil 21 and the receiver coil 22 partially overlap. The sender coil 21 can be arranged around the center of the receiver coil 22. The first partial coil 23 and the second partial coil 24 can each be larger than the receiver coil 22. The second partial coil 24 has the same winding direction as the receiver coil 22. The sender coil 21 and the receiver coil 22 can have the same orientation with respect to the linear asset 25 as shown in figure 2.

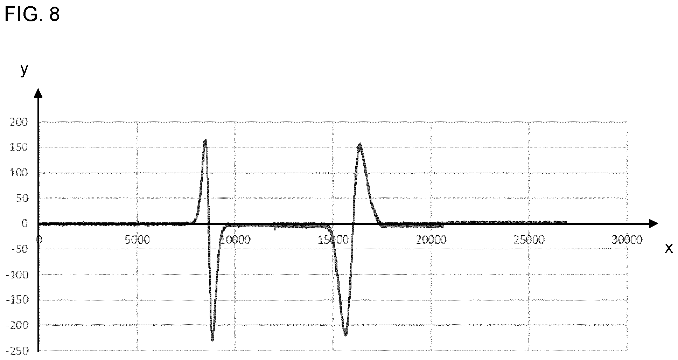

Figure 8 shows a signal detected with the sensor arrangement 20 according to an exemplary embodiment. The detected signal can for example be proportional to a voltage induced in the receiver coil 22. This voltage can be measured with a voltmeter 27 connected with the receiver coil 22. On the x-axis the time is plotted. On the y-axis the amplitude is plotted. The signal is detected during a time frame within which twice a wheel 29 of a rail vehicle passes over the linear asset 25 at the position where the sensor arrangement 20 is arranged. At first, the wheel 29 passes along a forward direction and at second the wheel 29 passes along a backward direction which is opposite to the forward direction. The first positive peak and the first negative peak relate to the passage of the wheel 29 along the forward direction. The second negative peak and the second positive peak relate to the passage of the wheel 29 along the backward direction. The sensor arrangement 20 has for example the setup shown in figure 1. Since the size of the first partial coil 23 is different from the size of the second partial coil 24, the first positive peak and the first and negative peak do not have the same shape. Therefore, also the integral over the first positive peak is different from the integral over the first negative peak. This allows a localization of the wheel 29 relative to the sensor arrangement 20 using amplitude information alone - without having to know the time axis as a prerequisite. This is advantageous for example in cases when the time axis has interruptions. Not having to know the time axis simplifies the measurement.

At approximately 13000 along the x-axis a strong current is provided to the linear asset 25 which is a rail. The amplitude of the detected signal has the same shape for the backwards passage (with the rail current) as for the forward passage (without the rail current). That the detected signal does not change significantly for the case that the strong rail current is provided, shows that a change in inductive coupling between the sender coil 21 and the receiver coil 22 nullifies for a change of electrical or magnetic properties of the linear asset 25, the change being homogenous along at least a part of the linear asset 25.

### Reference numerals

20 sensor arrangement
21 sender coil
22 receiver coil
23 first partial coil
24 second partial coil
25 linear asset
26 third partial coil
27 voltmeter
28 carrier
29 wheel
30 power source
x main extension direction

## Claims

1. Sensor arrangement (20) comprising:
- at least one sender coil (21), and
- at least one receiver coil (22), wherein
- the sender coil (21) or the receiver coil (22) comprises at least one first partial coil (23) and at least one second partial coil (24),
- the first partial coil (23) and the second partial coil (24) each have at least one winding, and
- the winding direction of the first partial coil (23) is opposite to the winding direction of the second partial coil (24) so that a change in inductive coupling between the sender coil (21) and the receiver coil (22) nullifies for a change of electrical or magnetic properties of a linear asset (25) being arranged adjacent to the sensor arrangement (20), the change being homogenous along at least a part of the linear asset (25).

2. Sensor arrangement (20) according to the preceding claim, wherein the change of electrical or magnetic properties of the linear asset (25) is homogenous along at least a part of the linear asset (25) along the main extension direction (x) of the linear asset (25).

3. Sensor arrangement (20) according to one of the preceding claims, wherein the first partial coil (23) and the second partial coil (24) are arranged next to each other along the main extension direction (x) of the linear asset (25).

4. Sensor arrangement (20) according to one of the preceding claims, wherein the first partial coil (23) and the second partial coil (24) are connected in series.

5. Sensor arrangement (20) according to one of the preceding claims, wherein the coil axis of the first partial coil (23) extends parallel to the coil axis of the second partial coil (24) .

6. Sensor arrangement (20) according to one of the preceding claims, wherein the coil axis of the first partial coil (23) and the coil axis of the second partial coil (24) extend parallel to the coil axis of the sender coil (21) or to the coil axis of the receiver coil (22).

7. Sensor arrangement (20) according to one of the preceding claims, wherein the first partial coil (23) has the same winding direction as the sender coil (21) or the receiver coil (22).

8. Sensor arrangement (20) according to one of the preceding claims, wherein the first partial coil (23) has a shape and/or a size that is different from the shape and/or size of the second partial coil (24).

9. Sensor arrangement (20) according to one of the preceding claims, wherein the first partial coil (23) has a number of windings that is different from the number of windings of the second partial coil (24).

10. Sensor arrangement (20) according to one of the preceding claims, wherein the sender coil (21) has a size that is different from the size of the receiver coil (22).

11. Sensor arrangement (20) according to one of the preceding claims, wherein the first partial coil (23) has a resonant frequency which is different from the resonant frequency of the second partial coil (24).

12. Sensor arrangement (20) according to one of the preceding claims, wherein the sender coil (21) or the receiver coil (22) comprises at least one third partial coil (26).

13. Sensor arrangement (20) according to one of the preceding claims, wherein the sensor arrangement (20) is mountable to the linear asset (25).

14. Sensor arrangement (20) according to one of the preceding claims, wherein the coil axis of the first partial coil (23) and/or the coil axis of the second partial coil (24) extend perpendicular to the plane on which the linear asset (25) is arranged.

15. Sensor arrangement (20) according to one of the preceding claims, wherein the first partial coil (23) and/or the second partial coil (24) is connected with a voltmeter (27).
